# EUROPÄISCHE PATENTSCHRIFT

(11) **EP 1 275 280 B1**
(45) Veröffentlichungstag und Bekanntmachung des Hinweises auf die Patenterteilung: **08.08.2007**
(21) Anmeldenummer: 01921319.8
(22) Anmeldetag: 07.03.2001
(51) Int. Cl.: H05K 9/00, H01R 13/719, H05K 5/00

(54) **ENTSTÖREINRICHTUNG**
INTERFERENCE SUPPRESSOR
DISPOSITIF DE SUPPRESSION DES INTERFERENCES

(30) Priorität: 20.04.2000 DE 10019886; 22.08.2000 DE 10041286
(43) Veröffentlichungstag der Anmeldung: 15.01.2003
(73) Patentinhaber: SIEMENS AKTIENGESELLSCHAFT, 80333 München (DE)
(72) Erfinder: BERBERICH, Reinhold, 60439 Frankfurt (DE); BUSCH, Dieter, 61191 Rosbach (DE)
(86) Internationale Anmeldenummer: PCT/EP2001/002559
(87) Internationale Veröffentlichungsnummer: WO 2001/082670

(56) Entgegenhaltungen:
- DE-A- 3 326 629
- US-A- 4 079 343
- US-A- 4 473 755
- US-A- 4 668 873
- US-A- 5 905 627
- PATENT ABSTRACTS OF JAPAN vol. 1999, no. 05, 31. Mai 1999 (1999-05-31) & JP 11 044600 A (MATSUSHITA ELECTRIC WORKS LTD), 16. Februar 1999 (1999-02-16)
- PATENT ABSTRACTS OF JAPAN vol. 018, no. 458 (E-1596), 25. August 1994 (1994-08-25) & JP 06 151014 A (MITSUBISHI MATERIALS CORP), 31. Mai 1994 (1994-05-31)

## Beschreibung

Die Erfindung betrifft eine Entstöreinrichtung für ein elektronisches Gerät, mit einer mindestens ein Steckelement aufweisenden Steckeinrichtung, die zur Befestigung an einem Gehäuse des elektronischen Gerätes ausgebildet ist, wobei ein Kondensator zur Verbesserung der elektromagnetischen Empfindlichkeit vorgesehen ist vgl. Patent Abstracts of Japan, Band 018, Nr 458/E-1596 25.08.1994.

Um eine einwandfreie Funktion von elektronischen Einrichtungen zu gewährleisten, ist es erforderlich, diese gegenüber Störstrahlungen, welche insbesondere im Hochfrequenzbereich auftreten, abzuschirmen. Solche Entstörmaßnahmen werden üblicherweise auf einer, im Inneren des elektronischen Gerätes befindlichen Leiterplatte vorgenommen.

Aus der DE 33 26 629 C2 ist ein Störschutz-Filter für elektronische Steuergeräte im Kraftfahrzeug bekannt, wobei das Störschutz-Filter im Gehäuse direkt am Eingang der Steckeranschlüsse angeordnet ist. Ein kapazitiv wirkendes Schaltglied weist dabei zwei Kondensatorplatten auf, wobei eine Kondensatorplatte als Leitung ausgebildet ist, die von dem in das elektronische Gerät hineinragenden Enden eines Steckers zu der elektronischen Schaltung führt.

Nachteilig ist dabei, daß durch diese Entstöreinrichtung Störstrahlungen nur gedämpft werden können, da die mit der Entstöreinrichtung verbundene Zufuhrleitung weiterhin Leistung abstrahlt, welche sich negativ auf die Elektronikkomponenten auswirkt.

Üblicherweise zur Entstörung genutzte, in Metallgehäuse eingelötete Standard-Durchführungskondensatoren sind teuer und aufwendig in der Verarbeitung.

Der Erfindung liegt somit die Aufgabe zugrunde, eine einfache und billige Entstörmaßnahme für elektronische Geräte anzugeben, welche auch für Massenproduktionen geeignet sind.

Erfindungsgemäß wird die Aufgabe dadurch gelöst, dass die erste Kondensatorplatte aus dem Steckelement selbst ausgeformt ist oder die erste Kondensatorplatte von einer auf einem Trägerelement angeordneten Leiterfläche gebildet ist, neben dem Steckelement angeordnet und mit diesem elektrisch verbunden ist.

Die Erfindung hat den Vorteil, dass die Entstörung bereits auf der Außenseite des elektronischen Gerätes erfolgt, und Störstrahlungen gar nicht erst in das Gehäuseinnere gelangen. Eine solche Entstöreinrichtung ist einfach zu montieren, da mit dem Einsatz des Steckers in das Gehäuse ein Entstörfilter entsteht. Zusätzliche Montagemaßnahmen entfallen.

Um auf Leitungen zum Kondensator verzichten zu können, ist eine erste Kondensatorplatte in oder an der Steckeinrichtung ausgebildet.

Die erste Kondensatorplatte kann z. B. durch Stauchung des Steckerstiftes einfach realisiert werden. Die Herstellung des Steckers wird somit weiter vereinfacht.

Alternativ ist die erste Kondensatorplatte von einer auf einem Trägerelement angeordneten Leiterfläche gebildet, die neben dem Steckelement angeordnet und mit diesem elektrisch verbunden ist. Dies erfolgt einfach, indem die erste Kondensatorfläche form- und/oder kraftschlüssig das isolationsfreie, ein elektrisches Potential führende Steckelement umschließt. Somit entsteht eine für die Massenfertigung besonders gut handhabbare Einrichtung.

Vorteilhafterweise weist das Trägerelement mindestens eine weitere, die zweite Kondensatorplatte bildende Leiterfläche auf, welche ober- und/oder unterhalb der ersten Leiterfläche, elektrisch gegen diese isoliert, angeordnet ist. Das Trägerelement mit den beiden Kondensatorplatten kann vorgefertigt werden, so dass bei der Steckermontage nur noch die elektrische Verbindung hergestellt werden muß.

In einer Weiterbildung der Erfindung ist eine, die zweite Kondensatorplatte bildende Leiterfläche als Kontaktschicht auf einer Oberfläche des Trägerelementes ausgebildet. Dabei bestehen zwei Möglichkeiten die elektrische Verbindung zum Gehäusepotential herzustellen.

Einmal liegt die elektrisch leitende Kontaktschicht des Trägerelementes direkt auf der Außenseite des Gehäuses auf, wodurch eine leitende Verbindung entsteht und die Kontaktschicht Gehäusepotential annimmt. Bei dieser Anordnung wird vollständig auf zusätzliche leitende Verbindungen verzichtet.

Vorteilhafterweise ist die Kontaktschicht als leitfähiger Kleber ausgebildet, so dass gleichzeitig eine Befestigung der Trägerelementes am Gehäuses erreicht wird.

In einer anderen Ausgestaltung erfolgt die elektrische Verbindung zwischen der, die zweite Kondensatorplatte bildenden Leiterfläche des Trägerelementes und dem Gehäuse durch mindestens ein, das Trägerelement und/oder die Steckeinrichtung am Gehäuse haltendes Befestigungselement.

Das Gehäusepotential wird dabei über an sich vorhandene Schraub-, Niet- oder Preßverbindungen an mindestens einem Punkt realisiert.

Bei Ausbildung der zweiten Leiterfläche als Kontaktfläche wird zwischen dieser und der Außenseite des Gehäuses eine Isolierung angeordnet. Die Steckeinrichtung liegt auch hier unveränderlich und fest auf der Gehäuseaußenwandung auf.

Zur Bildung eines weiteren Kondensators für dasselbe Steckelement weist das Trägerelement zwei weitere übereinanderliegende, elektrisch gegeneinander isolierte Leiterflächen auf, wobei die dritte Leiterfläche elektrisch mit dem Steckelement und die vierte Leiterfläche elektrisch mit dem Gehäusepotential verbunden ist. Durch diesen mehrschichtigen Aufbau können größere Kapazitätswerte pro Steckerpin realisiert werden.

In einer einfachen Ausgestaltung weist die Steckeinrichtung mehrere Steckelemente auf, wobei die ersten, elektrisch gegeneinander isolierten, zu verschiedenen Steckelementen gehörenden Kondensatorflächen in einer Leiterschicht ausgebildet sind.

Die zweite Kondensatorfläche wird für alle Steckelemente durch die unstrukturierte Kontaktschicht gebildet. Eine solche Anordnung läßt sich einfach durch Filmleiterplatten realisieren.

In einer vorteilhaften Weiterbildung ist das Trägerelement auf der dem Gehäuse zugewandten Seite derart aufsetzbar und kontaktierbar, dass je eine erste Leiterfläche je ein Steckelement umschließt.

Somit kann ein kommerziell erhältlicher Stecker mit einer zusätzlichen erfindungsgemäßen Entstöreinrichtung versehen werden.

Die Erfindung läßt zahlreiche Ausführungsformen zu. Eine davon soll anhand der in der Zeichnung dargestellten Figuren näher erläutert werden. Es zeigt:
- Figur 1:: Schnitt durch ein Steuergerät
- Figur 2:: erste Ausführungsform der Entstörplatine
- Figur 3:: zweite Ausführungsform der Entstörplatine
- Figur 4:: dritte Ausführungsform der Entstörplatine

Gleiche Merkmale sind mit gleichen Bezugszeichen gekennzeichnet.

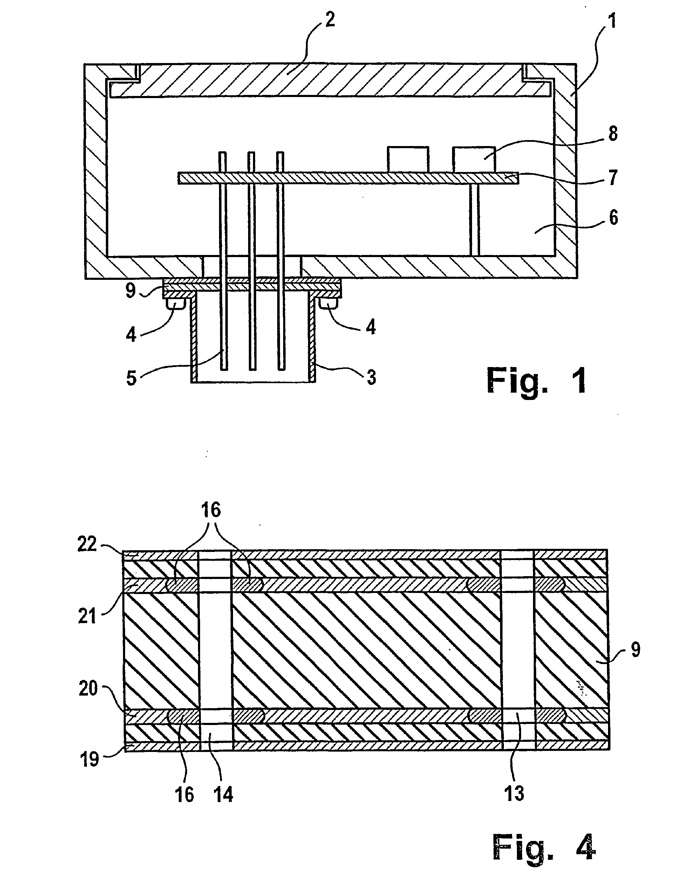

In Figur 1 ist ein elektrisches Gerät dargestellt, wie es üblicherweise in Kraftfahrzeugen Anwendung findet. Dabei kann es sich um ein Steuergerät eines Kraftfahrzeuges handeln, welches eine signalverarbeitende Elektronik aufweist, die bekannterweise sehr störanfällig gegenüber hohen Frequenzen ist. Es ist aber auch vorstellbar, dass das elektronische Gerät eine Sensoreinrichtung darstellt, welche neben einem eigentlichen Sensor eine Signalaufbereitungsschaltung und/oder eine Signalauswerteschaltung aufweist, die auf einer oder mehreren Leiterplatten angeordnet sind.

Das elektronische Gerät besitzt ein aus Aluminium bestehendes, becherförmiges Gehäuseteil 1, welches mit einer Abdeckung 2 verschlossen ist.

Das becherförmige Gehäuseteil 1 weist einen Steckerkörper 3 auf, welcher am Gehäuseteil 1 mittels Schrauben oder Nieten 4 außenseitig befestigt ist. Die Steckerpins 5 des Steckerkörpers 3 ragen sowohl in den Steckerkörper 3 als auch in das Gehäuseinnere 6. Der Stecker 3 verbindet über die Steckerpins 5 die Schaltungen des Gerätes mit anderen elektronischen Einrichtungen im Kraftfahrzeug.

Im Gehäuseinneren 6 ist mindestens eine Leiterplatte 7 angeordnet, welche Bauelemente 8 trägt, die die elektronischen Schaltungen realisieren. Die in das Gehäuseinnere 6 hineinragenden Steckerpins 5 sind elektrisch zur Zuführung von Signalen und elektrischer Leistung mit dem auf der Leiterplatte 7 befindlichen Bauelementen 8 verbunden.

Zwischen dem Stecker 3 und der Außenseite des Gehäuseteiles 1 ist eine Entstörplatine 9 eingelegt, welche gemeinsam mit dem Stecker 3 am Gehäuseteil 1 befestigt ist.

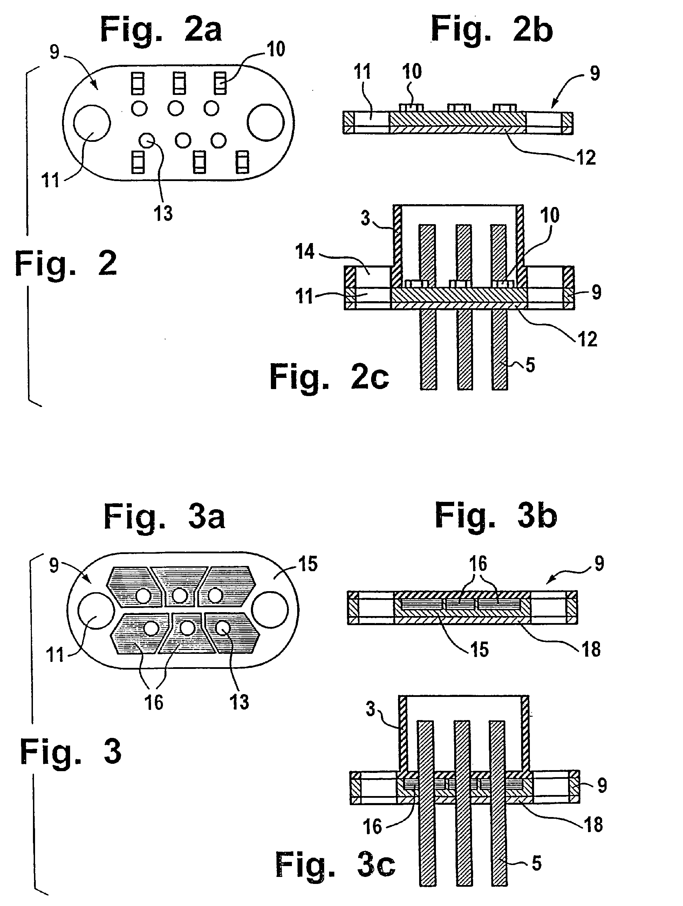

Verschiedene Ausführungsformen der Entstörplatine 9 sind in den Figuren 2 - 4 näher erläutert.

Figur 2 zeigt eine Entstörplatine 9 mit Öffnungen 13 für die Steckerpins 5. Neben diesen Öffnungen 13 ist für jeden Steckerpin 5 ein diskreter Kondensator 10 vorgesehen, der mittels einer auf der Platine 9 angeordneten Verdrahtung so verschaltet ist, dass jeder Kondensator 10 einerseits mit dem Steckerpinpotential und andererseits mit dem Potential des Gehäuses 1 verbunden ist. Das Gehäusepotential ist dabei üblicherweise auf Masse gelegt.

Die vorgefertigte Platine 9 wird über die Steckerpins 5 geschoben, wobei eine umlaufende Steckerdichtung 12 die Entstörplatine 9 an deren Rand umschließt und gleichzeitig abdichtet. Mit Schrauben 4, welche in die Öffnungen 11 der Entstörplatine 9 und die Öffnungen 14 des Steckerkörpers 3 eingreifen, wird die Entstörplatine 9 an der Außenhaut des Gehäuseteils 1 befestigt. Die Befestigung erfolgt dabei so, dass die Dichtung 12 auf dem Gehäuseteil 1 aufliegt. Die Schrauben 4 verbinden die Kondensatoren 10 gleichzeitig elektrisch mit dem Gehäusepotential.

Eine andere Ausführungsform, bei welcher Kapazitäten in der Entstörplatine 9 integriert sind, ist in Figur 3 dargestellt. Die Entstörplatine 9 ist als bauteillose Platine, z.B als Filmleiterplatte ausgebildet und weist eine strukturierte Leiterschicht 15 auf. Die Struktur entspricht einzelnen, gegeneinander isolierten Kondensatorflächen 16. Für jeden Steckerpin 5 ist dabei eine Kondensatorfläche 16 vorgesehen, welche die Öffnung 13 des jeweiligen Steckerpins 5 umschließt. Diese Öffnungen 13 sind metallisiert , wobei jede Kondensatorfläche 16 an der Grenzfläche mit der metallisierten Öffnung 13 verbunden ist, wodurch eine elektrische Verbindung entsteht. Nach Einfügen der Steckerpins 5 liegen die Kondensatorflächen 16 auf Steckerpotential. Bei dieser Ausführung sind als elektrische Verbindungsmechanismen Einpressvorgänge für die Kontaktierung von besonderem Vorteil, wo die Steckelemente 5 durch Einpressen in die Entstörplatine 9 kontaktiert werden. Verfügt das Steckelement 5 über nicht weiter dargestellte zwei Einpreßzonen, wird durch das Einpressen sowohl die Entstörplatine 9 als auch die Leiterplatte 7 kontaktiert.

Die Filterplatte 9 weist auf der dem Gehäuse zugewandten Oberfläche eine weitere Leitschicht 18 auf, welche direkt nach Montage des Steckers 3 auf dem Gehäuse 1 aufliegt. Sie nimmt somit das Gehäusepotential an, wobei das leitend ausgebildete Gehäuse 1 die zweite Kondensatorplatte bildet. Die unstrukturierte Leitfläche 18 ist vorzugsweise als Leitkleber ausgebildet, um die Entstörplatine 9 am Gehäuse zu befestigen.

Auf Grund dieser Ausgestaltung wirkt jeder Steckerpin 5 selbst als Kondensatorplatte und bildet mit dem mit Masse verbundenen Gehäuseteil 1 einen Entstörkondensator.

Eine weitere Ausführungsform ist in Figur 4 dargestellt. Die Entstörplatine 9 ist als mehrschichtige, aus miteinander verpreßten Leiterflächen-Schichten mit dazwischenliegenden gewebeverstärkten Kunstharzschichten ausgebildet (FR4-Basismaterial). Gemäß dieser Ausführung ist die Filterplatine 9 mit vier Kupferlagen 19, 20, 21, 22 versehen. Je eine Kupferlage 19 und 22 ist auf je einer der beiden Außenseiten der Platine 9 angeordnet. Innerhalb der Entstörplatine 9 befinden sich, voneinander isoliert, zwei weitere Kupferlagen 20, 21, welche die Kondensatorflächen 16 bilden, wie sie im Zusammenhang mit Figur 3 beschrieben wurden.

Die beiden äußeren Kupferlagen 19, 22 sind über die Befestigungselemente 4 mit dem Gehäusepotential verbunden und gegen das Potential, welches die Steckerpin 5 führen, elektrisch isoliert. Diese Kupferlagen 19, 22 sind über mehrere, nicht weiter dargestellte Durchkontaktierungen verbunden, welche so angeordnet sind, dass sie die Kondensatorflächen 16 umschließen, wodurch eine Abschirmung erreicht wird. Die Kondensatorflächen 16 sind in der schon beschriebenen Weise elektrisch mit den Steckerpins 5 verbunden. Somit werden pro Steckerpin 2 Kondensatoren realisiert. Werden noch mehr Kondensatoren benötigt, so lassen sich diese einfach durch weiteren abwechselnden Einbau von Kupferlagen 20, 21, die die strukturierten Kondensatorflächen 16 bilden und unstrukturierten, ganzflächig ausgebildeten Kupferlagen 19, 22, welche auf Gehäusepotential liegen, erreichen.

Bei Notwendigkeit können eine Vielzahl solcher gegeneinander isolierte Leiterflächen 19, 20, 21, 22 innerhalb der Entstörplatine angeordnet sein.

Neben der erläuterten Ausführung können die Kondensatorflächen 16 auch mit Hilfe von Stanzteilen oder Kaptonfolien gebildet werden, welche in ein isolierendes Material eingebettet sind. Je nach dem zur Umhüllung der Kondensatorplatten verwendetem Material bzw. Materialkombination kann dieses gleichzeitig Dichtungsaufgaben wahrnehmen.

Diese erfindungsgemäßen Kondensatorflächen bilden gegenüber dem Außengehäuse Kapazitäten im Bereich bis zu 100 pF. Neben einer direkten elektrischen Verbindung zwischen Kondensator und Steckelement 5 bzw. dem elektrisch leitenden Gehäuse 1 ist es zur Verbesserung der elektromagnetischen Empfindlickeit aber auch ausreichend, wenn eine kapazitive Kopplung erfolgt. Entscheidend ist, dass die den Kondensator bildende Entstörplatine 9 selbst nicht von einem elektrisch leitendem Gehäuse umgeben ist. Vorteilhafterweise ist die Entstörplatine 9 dabei in einem Kunststoffgerätestecker intergriert oder von einem solchen umgeben.

## Patentansprüche

1. Entstöreinrichtung für ein elektronisches Gerät mit einer, mindestens ein Steckelement aufweisenden Steckeinrichtung, die zur Befestigung an einem Gehäuse des elektronischen Gerätes ausgebildet ist, wobei ein Kondensator zur Verbesserung der elektromagnetischen Empfindlichkeit vorgesehen ist, wobei der Kondensator (10) außerhalb des Gehäuses (1, 2) des elektronischen Gerätes angeordnet ist und elektrisch einerseits mit einem Steckelement (5) der Steckeinrichtung (3) und andererseits mit dem Potential des elektrisch leitend ausgebildeten Gehäuses (1, 2) verbunden ist und eine erste Kondensatorplatte (16) des Kondensators (10) in oder an der Steckeinrichtung (3) angeordnet ist, **dadurch gekennzeichnet, dass** die erste Kondensatorplatte (16) aus dem Steckelement (5) selbst ausgeformt ist oder die erste Kondensatorplatte (16) von einer auf einem Trägerelement (9) angeordneten Leiterfläche (15) gebildet ist, neben dem Steckelement (5) angeordnet und mit diesem elektrisch verbunden ist.

2. Entstöreinrichtung nach Anspruch 1, **dadurch gekennzeichnet, dass** das Trägerelement (9) mindestens eine weitere, eine zweite Kondensatorfläche bildende Leitefläche (18) aufweist, welche ober- und/oder unterhalb der ersten Leiterfläche (15), elektrisch gegen diese isoliert, angeordnet ist.

3. Entstöreinrichtung nach Anspruch 2, **dadurch dadurch gekennzeichnet, dass** die elektrische Verbindung zwischen der zweiten Leiterfläche (18) des Trägerelementes (9) und dem Gehäuse (1, 2) durch mindestens ein, das Trägerelement (9) und/oder die Steckverbindung (3) am Gehäuse (1, 2) haltendes Befestigungselement (4) erfolgt.

4. Entstöreinrichtung nach Anspruch 2, **dadurch ge- kennzeichnet, dass** die, die zweite Kondensatorplatte bildende Leitefläche (18) als Kontaktschicht auf der Oberfläche des Trägerelementes (9) ausgebildet ist.

5. Entstöreinrichtung nach Anspruch 3 und 4, **dadurch gekennzeichnet, dass** eine Isolierung (17) zwischen der Kontaktschicht (18) und der Außenseite des Gehäuses (1, 2) angeordnet ist.

6. Entstöreinrichtung nach Anspruch 2 und 4, **dadurch gekennzeichnet, dass** die Kontaktschicht (18) des Trägerelementes (9) direkt auf der Außenseite des Gehäuses (1, 2) aufliegt.

7. Entstöreinrichtung nach Anspruch 6, **dadurch gekennzeichnet, dass** die Kontaktsicht (18) als leitfähiger Kleber ausgebildet ist.

8. Entstöreinrichtung nach Anspruch 1 und 2, **dadurch gekennzeichnet, dass** das Trägerelement (9) zur Bildung eines weiteren Kondensators für dasselbe Steckelement (5) zwei weitere übereinander liegende, elektrisch gegeneinander isolierte Leitflächen (19, 20; 21, 22) aufweist, wobei die dritte Leitefläche (20, 21) elektrisch mit dem Steckelement (5) und die vierte Leiterfläche (19, 22) elektrisch mit dem Gehäusepotential verbunden ist.

9. Entstöreinrichtung nach Anspruch 8, **dadurch gekennzeichnet, dass** die Steckeinrichtung (3) mehrere Steckelemente (5) aufweist, wobei die ersten, elektrisch gegeneinander isolierten, zu verschiedenen Steckelementen (5) gehörenden Kondensatorflächen (16) in einer Leiterschicht (15) ausgebildet sind.

10. Entstöreinrichtung nach Anspruch 8, **dadurch gekennzeichnet, dass** die zweite Kondensatorfläche für alle Steckelemente (5) durch die unstrukturierte Kontaktschicht (18) gebildet ist.

11. Entstöreinrichtung nach einem der vorhergehenden Ansprüche, **dadurch gekennzeichnet, dass** das Trägerelement (9) auf der dem Gehäuse (1, 2) zugewandten Seite der Steckeinrichtung (3) derart aufsetzbar und kontaktierbar ist, dass je eine erste Kondensatorfläche (16) je ein Steckelement (5) umschließt.

## Claims

1. Suppression device for an electronic appliance having a plug-in device which has at least one plug-in element and is designed for attachment to a housing of the electronic appliance, with a capacitor being provided in order to improve the electromagnetic sensitivity, in which the capacitor (10) is arranged outside the housing (1, 2) of the electronic appliance and is electrically connected firstly to a plug-in element (5) of the plug-in device (3) and secondly to the potential of the electrically conductive housing (1, 2) and a first capacitor plate (16) of the capacitor (10) is arranged in or on the plug-in device (3), **characterized in that** the first capacitor plate (16) is formed from the plug-in element (5) itself or the first capacitor plate (16) is formed by a conductor surface (15) arranged on a mounting element (9), is arranged alongside the plug-in element (5) and is electrically connected to it.

2. Suppression device according to claim 1, **characterized in that** the mounting element (9) has at least one further conductor surface (18), which forms a second capacitor surface and is arranged above and/or underneath the first conductor surface (15), electrically isolated from it.

3. Suppression device according to claim 2, **characterized in that** the electrical connection between the second conductor surface (18) of the mounting element (9) and the housing (1, 2) is produced by means of at least one attachment element (4), which holds the mounting element (9) and/or the plug-in connection (3) on the housing (1, 2).

4. Suppression device according to claim 2, **characterized in that** the conductor surface (18) which forms the second capacitor plate is in the form of a contact coating on the surface of the mounting element (9).

5. Suppression device according to claims 3 and 4,
**characterized in that** insulation (17) is arranged between the contact coating (18) and the outside of the housing (1, 2).

6. Suppression device according to claims 2 and 4, **characterized in that** the contact coating (18) of the mounting element (9) is located directly on the outside of the housing (1, 2).

7. Suppression device according to claim 6, **characterized in that** the contact coating (18) is in the form of conductive adhesive.

8. Suppression device according to claims 1 and 2, **characterized in that** the mounting element (9) has two further conductor surfaces (19, 20; 21, 22), which are located one above the other and are electrically isolated from one another, in order to form a further capacitor for the same plug-in element (5), with the third conductor surface (20, 21) being electrically connected to the plug-in element (5) and the fourth conductor surface (19, 22) being electrically connected to the housing potential.

9. Suppression device according to claim 8, **characterized in that** the plug-in device (3) has a number of plug-in elements (5), with the first capacitor surfaces (16), which are electrically isolated from one another and are associated with different plug-in elements (5), being formed in a conductor coating (15).

10. Suppression device according to claim 8, **characterized in that** the second capacitor surface is formed by the unstructured contact coating (18) for all the plug-in elements (5).

11. Suppression device according to one of the preceding claims, **characterized in that** the mounting element (9) can be fitted on that side of the plug-in device (3) which faces the housing (1, 2) and can be made contact with **in that** a first capacitor surface (16) in each case encloses in each case one plug-in element (5).

## Revendications

1. Dispositif antiparasite pour appareil électronique, comprenant au moins un dispositif enfichable comportant un élément enfichable, ledit dispositif enfichable étant conçu pour la fixation à un boîtier de l'appareil électronique, où il est prévu un condensateur pour améliorer la sensibilité électromagnétique, où le condensateur (10) est placé à l'extérieur du boîtier (1, 2) de l'appareil électronique et est relié électriquement, d'un côté, à un élément enfichable (5) du dispositif enfichable (3) et, de l'autre côté, au potentiel du boîtier (1, 2) conçu conduisant l'électricité et où une première plaque (16) du condensateur (10) est placée dans ou sur le dispositif enfichable (3), **caractérisé par le fait que** la première plaque (16) de condensateur est ménagée à partir de l'élément enfichable (5) lui-même ou que la première plaque (16) de condensateur est formée par une surface conductrice (15) disposée sur l'élément support (9), placée près de l'élément enfichable (5) et reliée électriquement à celui-ci.

2. Dispositif antiparasite selon la revendication 1, **caractérisé** p a r le fait que l'élément support (9) comporte au moins une autre surface conductrice (18) formant une deuxième surface de condensateur, ladite surface conductrice étant placée au-dessus et/ou au-dessous de la première surface conductrice (15) et étant isolée électriquement par rapport à cette dernière.

3. Dispositif antiparasite selon la revendication 2, **carac- térisé** par le fait que la liaison électrique entre la deuxième surface conductrice (18) de l'élément support (9) et le boîtier (1, 2) se fait par au moins un élément de fixation (4) maintenant l'élément support (9) et / ou la liaison enfichable (3) sur le boîtier (1, 2).

4. Dispositif antiparasite selon la revendication 2, **caractérisé par le fait que** la surface conductrice (18) formant la deuxième plaque de condensateur est conçue comme couche de contact sur la surface de l'élément support (9).

5. Dispositif antiparasite selon la revendication 3 et 4, **caractérisé par le fait qu'**une isolation (17) est disposée entre la couche de contact (18) et la face extérieure du boîtier (1, 2).

6. Dispositif antiparasite selon la revendication 2 et 4, **caractérisé par le fait que** la couche de contact (18) de l'élément support (9) est appliquée directement sur la face extérieure du boîtier (1, 2).

7. Dispositif antiparasite selon la revendication 6, **carac- térisé par** le fait que la couche de contact (18) est conçue comme colle conduisant l'électricité.

8. Dispositif antiparasite selon la revendication 1 et 2, **caractérisé par le fait que** l'élément support (9) comporte, pour former un autre condensateur pour le même élément enfichable (5), deux autres surfaces conductrices (19, 20; 21, 22) se trouvant l'une au-dessus de l'autre et isolées électriquement l'une par rapport à l'autre, la troisième surface conductrice (20, 21) étant reliée électriquement à l'élément enfichable (5) et la quatrième surface conductrice (19, 22) étant reliée électriquement au potentiel du boîtier.

9. Dispositif antiparasite selon la revendication 8, **carac- térisé par** le fait que le dispositif enfichable (3) comporte plusieurs éléments enfichables (5), les premières surfaces de condensateur (16) isolées électriquement l'une par rapport à l'autre et faisant partie de différents éléments enfichables (16) étant conçues dans une couche conductrice (15).

10. Dispositif antiparasite selon la revendication 8, carac-térisé par le fait que la deuxième surface de condensateur est conçue pour tous les éléments enfichables (5) par la couche de contact non structurée (18).

11. Dispositif antiparasite selon l'une des revendications précédentes, **caractérisé par le fait que** l'élément support (9) peut être mis en place et mis en contact électrique sur la face du dispositif enfichable (3) tournée vers le boîtier (1, 2) de manière telle que chaque première surface de condensateur (16) enveloppe un élément enfichable (5).
